Europäisches Patentamt

European Patent Office

Office européen des brevets

(11) Veröffentlichungsnummer: **0 401 663**
**A2**

## (12) EUROPÄISCHE PATENTANMELDUNG

(21) Anmeldenummer: **90110250.9**

(51) Int. Cl.⁵: **C23C 14/06**

(22) Anmeldetag: **30.05.90**

(30) Priorität: **07.06.89 DE 3918582**

(43) Veröffentlichungstag der Anmeldung:
**12.12.90 Patentblatt 90/50**

(84) Benannte Vertragsstaaten:
**DE FR GB NL**

(71) Anmelder: **BASF Aktiengesellschaft**
**Carl-Bosch-Strasse 38**
**D-6700 Ludwigshafen(DE)**

(72) Erfinder: **Harth, Klaus, Dr.**
**Starenweg 6**
**D-6719 Altleiningen(DE)**
Erfinder: **Hibst, Hartmut, Dr.**
**Sternstrasse 215**
**D-6700 Ludwigshafen(DE)**
Erfinder: **Sonnberger, Ralf, Dr.**
**Goethestrasse 8**
**D-6702 Bad Duerkheim(DE)**
Erfinder: **Steininger, Helmut, Dr.**
**Dr. Ernst-Kilb-Weg 15**
**D-6520 Worms 26(DE)**

(54) **Dünne unorientiert mikrokristalline Aluminiumnitridschicht auf einer Oberfläche und Verfahren zu ihrer Herstellung.**

(57) Die Erfindung betrifft eine dünne unorientiert mikrokristalline Aluminiumnitridschicht auf einer Oberfläche eines flächenförmigen Gegenstandes und Verfahren zu ihrer Herstellung durch reaktives DC-(Magnetron)-Kathodensputtern.

EP 0 401 663 A2

## Dünne unorientiert mikrokristalline Aluminiumnitridschicht auf einer Oberfläche und Verfahren zu ihrer Herstellung

Die vorliegende Erfindung betrifft eine dünne unorientiert mikrokristalline Aluminiumnitridschicht auf einer Oberfläche eines flächenförmigen Gegenstandes und verfahren zu ihrer Herstellung durch reaktives DC-(Magnetron)-Kathodensputtern.

Beim reaktiven Kathodensputtern wird das Material einer Kathode, dem Target, durch Beschuß mit Argonionen zerstäubt und in die Gasphase überführt. Dem in dieser Weise resultierenden Prozeßgas werden reaktive gasförmige Komponenten, wie Sauerstoff oder Stickstoff zugemischt, welche zusammen mit dem zerstäubten Kathodenmaterial auf der zu beschichtenden Oberfläche dann als dünne Oxid- oder Nitridschicht abgeschieden werden. Beim reaktiven Magnetronkathodensputtern befindet sich das Target in einem Magnetfeld. Durch die Variation von Verfahrensparametern wie Zerstäubungs- und Abscheiderate sowie Sputtergasdruck und -zusammensetzung können dünne Schichten unterschiedlicher Zusammensetzung und/oder unterschiedlicher Morphologie erzeugt werden.

Verfahren zur Herstellung dünner polykristalliner oder röntgenamorpher Aluminiumnitridschichten sind bekannt. So beschreibt u.a. die DE-A 35 00 314 ein Verfahren zur Herstellung einer Schicht aus einem Gemisch von Aluminiumnitrid und Aluminiumoxid durch reaktives Sputtern von Aluminium in einer Sputtergasatmosphäre aus einem Gemisch aus Stickstoff, Sauerstoff und Argon mit dem Volumenverhältnis von 2,5 : 0,5 : 7,0. Ein reiner Nitridfilm wird im Hinblick auf sein geringes Haftvermögen als nachteilig bezeichnet, ohne daß jedoch genaue Angaben über das Herstellverfahren und die damit zusammenhängende Morphologie der Schicht gemacht werden. Auch nach der US-PS 4 719 154 werden stickstoffhaltige Aluminiumschichten, allerdings mit einem hohen Anteil an Aluminium, niedergeschlagen. Das dort angewandte RF-Kathodensputtern ist jedoch wegen der starken Erwärmung des Substrats wenig vorteilhaft.

Auch in einer Reihe wissenschaftlicher Arbeiten ist wie in dem Artikel von J.M. Lagorsse und B. Serzec in Proceedings of the Seventh International Vacuum Congress and 3rd International Conference on Solid Surfaces, Wien 1977, Seiten 1995 bis 1997, die Herstellung von Aluminiumnitridschichten durch reaktives Kathodensputtern von Aluminium in Stickstoff oder in Stickstoff und Wasserstoff als Sputtergas,

in dem Artikel von F. Takeda, T. Mori und T. Takahashi in Japanese Journal of Applied Physics, Band 20, Nummer 3, März 1981, Seiten L164 bis L172, die Herstellung von Aluminiumnitridschichten durch reaktives Magnetronkathodensputtern von Aluminium in Stickstoff oder in Stickstoff und Wasserstoff als Sputtergas,

in dem Artikel von Li Xinjiao, Xu Zechuan, He Ziyou, Cao Huazhe, Su Wuda, Chen Zhongcai, Zhou Feng und Wang Enguang in Thin Solid Films, Band 139, 1986, Seiten 261 bis 274 die Herstellung von Aluminiumnitridschichten durch Hochfrequenzkathodensputtern von Aluminium in einem Gemisch aus Argon und Stickstoff im Volumenverhältnis von 1:1 als Sputtergas,

in dem Artikel von S. Bhat, S. Ashok, S.J. Fonash und L. Tongson in Journal of Electronic Materials, Band 14, Nummer 4, 1985, Seiten 405 bis 418, die Herstellung von Aluminiumnitridschichten durch reaktives Ionenstrahlsputtern in einem Gemisch aus Stickstoff und Wasserstoff und

in dem Artikel von C.R. Aita und C.J. Gawlak in Journal of Vacuum Science and Technology, Band A1, Nummer 2, April-Juni 1983, Seiten 403 bis 406, die Herstellung von amorphen Aluminiumnitridschichten durch Hochfrequenzkathodensputtern in einem Gemisch aus Argon und Stickstoff wechselnder Zusammensetzung als Sputtergas

bekannt.

Die bislang bekannten Verfahren zur Herstellung dünner Aluminiumnitridschichten weisen jedoch Nachteile auf. So läßt sich das bekannte Verfahren zur Herstellung dünner röntgenamorpher Aluminiumsiliciumnitridschichten nicht auf Aluminiumnitridschichten übertragen. Außerdem liefern die bislang bekannten Verfahren zur Herstellung dünner Aluminiumnitridschichten polykristalline Schichten, wobei die Orientierung der Kristallite zudem noch in hohem Maße von der Natur der Oberfläche, auf welche sie aufgebracht werden, abhängig ist. Zwar kann im gewissem Umfang die Orientierung der Kristallite (c-Achse senkrecht oder parallel zur Oberfläche) durch die Zugabe von Wasserstoff zum jeweils verwendeten Sputtergas Stickstoff oder Argon und Stickstoff geändert werden, doch läßt sich damit eine Ausrichtung der Kristallite in den Aluminiumnitridschichten nicht in beliebiger Weise kontrollieren.

Amorphe Aluminiumnitridschichten oder solche mit nichtkontrollierter Textur sind aus der Literatur bekannt, sie zeigen jedoch eine ungenügende intrinsische Hydrolysestabilität in feucht-warmer Umgebung.

Insbesondere haben die Bemühungen, Aluminiumnitridschichten als Korrosionsschutzschichten bereitzustellen, noch keinen Erfolg gehabt. So werden beispielsweise auf dem Gebiet der optischen Aufzeichnungsmaterialien Luft- und Wasserdampf-resistente Schutzschichten benötigt. Die nach den bekannten Verfahren erzeugten Aluminiumnitridschichten haben diese Anforderungen noch nicht zur Gänze erfüllt.

Aufgabe der vorliegenden Erfindung war es eine unorientiert mikrokristalline Aluminiumnitridschicht bereitzustellen, welche die bekannten Nachteile nicht aufweist. Weiterin war es Aufgabe der Erfindung, ein Verfahren zur Herstellung dieser Schichten aufzuzeigen.

Es wurde nun gefunden, daß eine dünne unorientiert mikrokristalline Aluminiumnitridschicht auf der Oberfläche eines flächenförmigen Gegenstands die geforderten Eigenschaften aufweist, wenn im Röntgenbeugungsdiagramm das Verhältnis der Intensität des (001)-Reflexes zu der des (101)-Reflexes kleiner 1, vorzugsweise kleiner 0,75 ist.

Die Bestimmung der Intensitäten der (001)- und (101)-Reflexe erfolgt in bekannter Weise mit einem automatisierten Pulver-Diffraktometer.

Ein weiterer Gegenstand der Erfindung ist ein Verfahren zur Herstellung dieser Schichten. So lassen sich die erfindungsgemäßen Aluminiumnitridschichten auf der Oberfläche eines flächenförmigen Gegenstandes durch reaktives DC-(Magnetron-)Kathodensputtern von Aluminium in einer Argon und Stickstoff enthaltenden Sputtergasatmosphäre und Abscheiden der Aluminiumnitridschicht aus der Gasphase auf die Oberfläche besonders vorteilhaft erhalten, wenn das Aluminium eines Aluminiumtargets durch DC-(Magnetron-)Kathodensputtern bei einer Kathodenleistung von 0,1 bis 5 kW, vorzugsweise 0,1 bis 1 kW, in einer Sputtergasatmosphäre aus Argon und Stickstoff in einem Mischungsverhältnis von 4:1 bis 25:1 als Aluminiumnitrid in einer Dicke von 0,4 bis 5 nm pro Sekunde, vorzugsweise 0,4 bis 2 nm pro Sekunde mit der Maßgabe abgeschieden wird, daß der Absorptionskoeffizient (k) kleiner 0,2 ist.

Zur Durchführung des erfindungsgemäßen Verfahrens lassen sich die bekannten und üblichen Sputteranlagen einsetzen. Auch ist das reaktive DC-Kathodensputtern als solches beschrieben (u.a. John L. Vossen, Werner Kern, "Thin Film Processes", Academic Press, New York, 1978, J.A. Thornton in "Deposition Technologies for Films and Coatings", ed. R.F. Bunshah, Moyes Publ., New Jersey, 1982).

Die zu beschichtenden Materialien können von unterschiedlichster Form und Zusammensetzung sein. So können beispielsweise Silicium- oder andere Halbleiter-Plättchen, Glas, Polymerfilme, Metallschichten, Farbstoffschichten usw. verwendet werden. Nach dem Einbringen des Aluminiumtargets und der zu beschichtenden Materialien werden die Anlagen auf ein Vakuum von $10^{-6}$ mbar oder weniger evakuiert. Gegebenenfalls schließt sich hieran eine Vorbehandlung der Targets oder der zu beschichtenden Oberfläche der Materialien an, wie etwa ein Sputtern und Abscheiden von Aluminium und/oder Silicium vom Target oder ein Ätzen der zu beschichtenden Oberfläche durch Sputtern mit Argonatomen. Nach dieser Vorbereitung wird das erfindungsgemäße Verfahren durchgeführt.

Die erfindungsgemäßen und nach dem angegebenen Verfahren besonders vorteilhaft hergestellten Aluminiumnitridschichten zeichnen sich durch eine besonders wirkungsvolle Schutzschichtfunktion aus. So lassen sich entsprechende Schichten als .Schutzschichten für integrierte Schaltkreise, optoelektronische Bauelemente oder als Interferenz- und/oder Schutzschichten in flächenförmigen laseroptischen und magneto-optischen Aufzeichnungsmaterialien mit wasser- und luftempfindlichen Aufzeichnungsschichten verwenden.

Gerade bei flächenförmigen laseroptischen und magneto-optischen Aufzeichnungsmaterialien treten die Vorteile der erfindungsgemäßen Schutzschichten besonders hervor. Diese flächenförmigen Aufzeichnungsmaterialien, welche im wesentlichen einen optisch transparenten dimensionsstabilen Träger und eine thermisch veränderbare Aufzeichnungsschicht aufweisen, sind bekannt. Dabei umfaßt der Begriff "flächenförmig" alle Raumformen, deren Dicke erheblich kleiner ist als ihre Länge und Breite. Demnach kann es sich hier um band-, platten- oder scheibenförmige Aufzeichnungsmaterialien handeln, wobei die scheibenförmigen im allgemeinen auch als Datenplatten oder Disks bezeichnet werden.

Eine besonders vorteilhafte Aufzeichnungsschicht, welche sich insbesondere für das ablative oder deformative Schreiben von Daten eignet, enthält z.B. das wasser- und luftempfindliche Tellur. Die erfindungsgemäße Aluminiumnitridschichten, welche nach dem erfindungsgemäßen Verfahren auf der Tellurschicht aufgebracht werden, schützen die Tellurschicht hervorragend vor Korrosion, verlängern ihre Lebensdauer und verbessern ihr Signal-Rausch-Verhältnis. Das gleiche gilt auch für die weiteren bekannten, meist korrodierbaren Aufzeichnungsschichten, so auch magnetooptische Schichten auf der Basis Seltene Erden/Übergangsmetalle.

Die aus dem Stand der Technik bekannten Aluminiumnitridschichten waren im Hinblick auf ihre Korrosionsschutzwirkung nicht voll befriedigend. Dieser Mangel trat insbesondere bei längerer Lagerung und vor allem in feuchtwarmer Umgebung auf. Hierbei zersetzt sich das Aluminium in feuchter Umgebungsluft unter Bildung verschiedener oxidischer Aluminiumverbindungen, vor allem dem AlOOH, und Ammoniak. Als beschleunigter Alterungs- bzw. Korrosionstest hat sich somit die Bestimmung der AlOOH-Bildung in Abhängigkeit von der Zeit angeboten. Dabei wird die Aluminiumnitridschicht einer relativen Luftfeuchte von 80 % bei 80° C ausgesetzt und die Dicke der sich bildenden AlOOH-Zersetzungsschicht (d in Nanometer) durch spektrale Ellipsometrie im Wellenlängenbereich von 350 bis 800 nm bestimmt.

Die Herstellung und die Eigenschaften der erfindungsgemäßen Aluminiumnitridschicht sei anhand folgender Beispiele näher erläutert und mit Schichten nach dem Stand der Technik verglichen.

Hierzu wurde in eine Gleichspannungs-Kathodenzerstäubungsanlage ein Al-Target mit einem Durchmesser von 200 mm eingesetzt. Parallel zu diesem Target wurde dann in einem Abstand zwischen 50 und 70 mm eine Glasplatte mit einem Durchmesser von 130 mm angeordnet. Durch Anlegen eines Gleichspannungs- bzw. Wechselspannungsplasmas wurden unter den in der Tabelle angegebenen Bedingungen Aluminiumnitridschichten mit Gesamtdicken im Bereich von 100 bis 1000 nm hergestellt.

Die Struktur der Aluminiumnitridschichten wurde röntgenographisch mit einem automatisierten Pulverdiffraktometer (D 500 der Fa. Siemens, München) untersucht. Dabei wurde eine Cu-K$_\alpha$-Strahlung verwendet. Die gefundene kristalline Orientierung ist in der Tabelle angegeben.

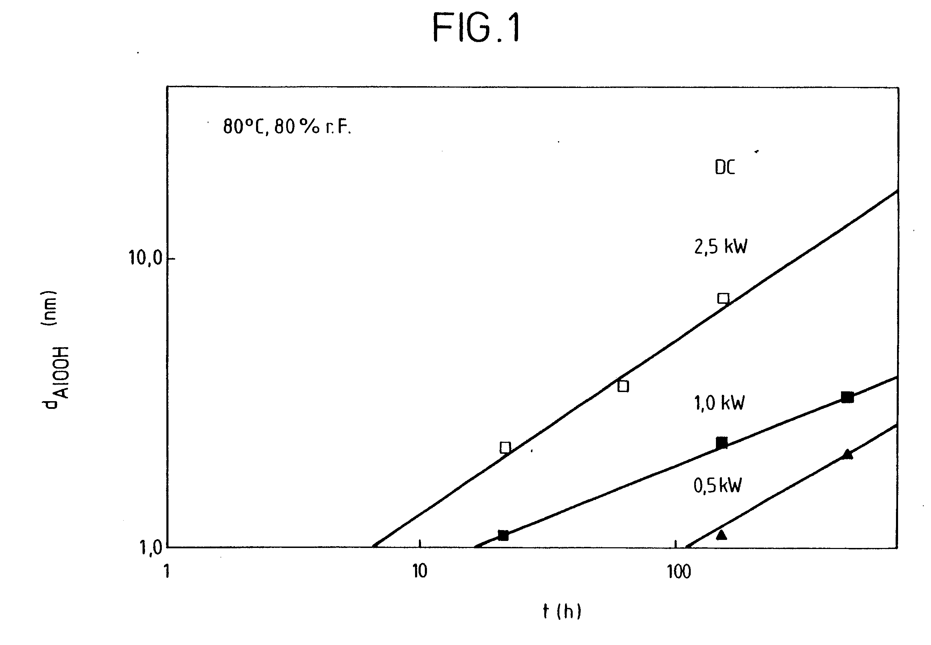

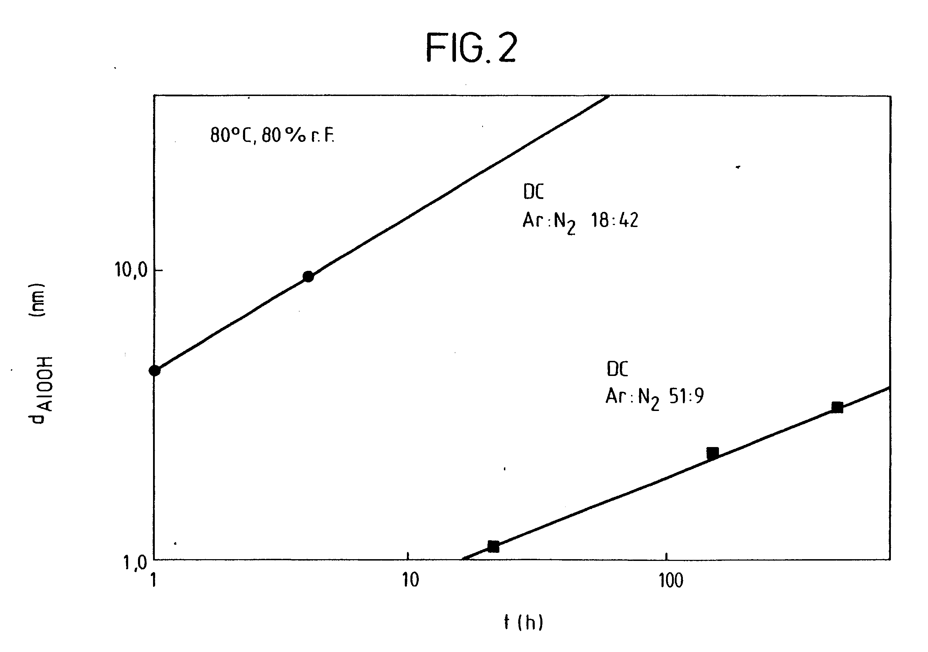

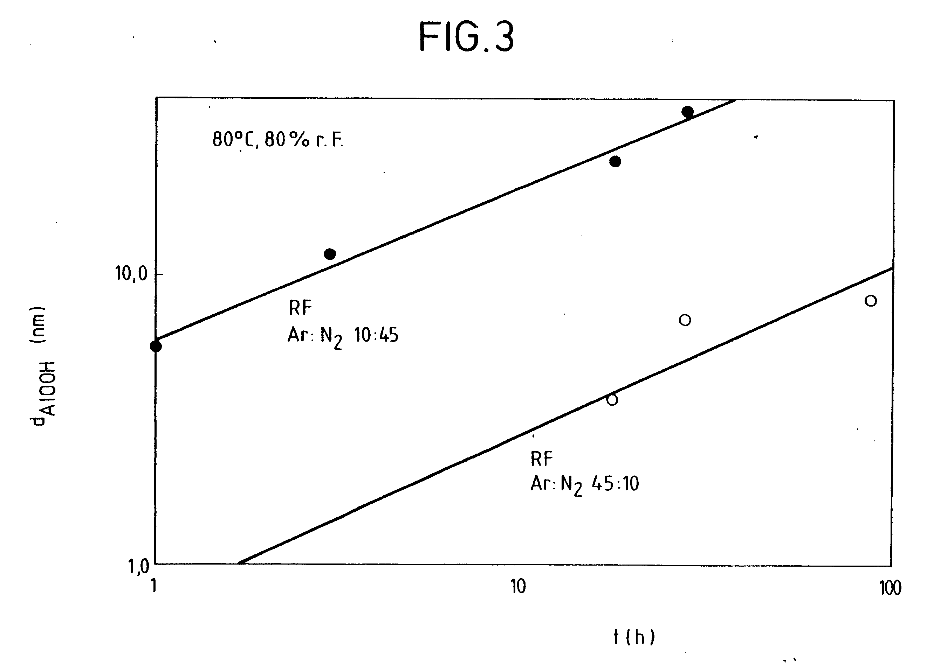

Diese Schichten wurden nun dem beschleunigten Alterungs- und Korrosionstest unterworfen und die Ausbildung der AlOOH-Schicht in Abhängigkeit von der Zeit elipsometrisch bestimmt. Die Ergebnisse sind in den Figuren 1 bis 3 wiedergegeben. Daraus läßt sich ablesen, daß die Aluminiumnitridschichten gemäß der Erfindung deutlich stabiler gegen korrosive Einflüsse als solche nach dem Stand der Technik, seien es solche mit einem anderen Argon-Stickstoff-Verhältnis (Beispiel 3) oder solche mit dem RF-Sputterprozeß gewonnenen (Beispiele 6 und 7).

Tabelle

| | Kathodenleistung [kW] | Sputterdruck [mbar] | Sputtergas Ar:N$_2$ | Abscheidungsrate [nm/s] | Absorpt. koeff. | Kristallstruktur | Korrosionstest |
|---|---|---|---|---|---|---|---|
| Beispiel 1 | 0,5 DC | $6 \cdot 10^{-3}$ | 54,6: 5,4 | 0,5 | <0,2 | mikrokristallin, (101)-Textur | Fig. 1 |
| Beispiel 2 | 1,0 DC | $6 \cdot 10^{-3}$ | 51 : 9 | 0,6 | <0;2 | mikrokristallin, starke (001)-Textur | Fig. 1, 2 |
| Beispiel 3 | 2,5 DC | $6 \cdot 10^{-3}$ | 47 :13 | 2,0 | <0,2 | mikrokristallin, starke (001)-Textur | Fig. 1 |
| Beispiel 5 | 1,0 DC | $6 \cdot 10^{-3}$ | 18 :42 | 0,4 | 0,2 | mikrokristallin, sehr starke (001)-Textur | Fig. 2 |
| Beispiel 6 | 1,0 RF | $5 \cdot 10^{-3}$ | 45 :10 | 0,6 | 0,2 | mikrokristallin, leichte (001)-Textur | Fig. 3 |
| Beispiel 7 | 1,0 RF | $5 \cdot 10^{-3}$ | 10 :45 | 0,4 | 0,2 | röntgenamorph | Fig. 3 |

**Ansprüche**

1. Dünne unorientiert mikrokristalline Aluminiumnitridschicht auf der Oberfläche eines flächenförmigen Gegenstands, dadurch gekennzeichnet, daß im Röntgenbeugungsdiagramm das Verhältnis der Intensität des (001)-Reflexes zu der des (101)-Reflexes kleiner 1 ist.

2. Verfahren zur Herstellung einer dünnen unorientiert mikrokristallinen Aluminiumnitridschicht auf der Oberfläche eines flächenförmigen Gegenstandes durch reaktives DC-(Magnetron-)Kathodensputtern von Aluminium in einer Argon und Stickstoff enthaltenden Sputtergasatmosphäre und Abscheiden der Aluminiumnitridschicht aus der Gasphase auf die Oberfläche, dadurch gekennzeichnet, daß das Aluminium eines Aluminiumtargets durch DC-(Magnetron-)Kathodensputtern bei einer Kathodenleistung von 0,1 bis 5 kW in einer Sputtergasatmosphäre aus Argon und Stickstoff in einem Mischungsverhältnis von 4:1 bis 25:1 als Aluminiumnitrid in einer Dicke von 0,4 bis 5 nm pro Sekunde mit der Maßgabe abgeschieden wird, daß der Absorptionskoeffizient (k) kleiner 0,2 ist.

# FIG.1

EP 0 401 663 A2

# FIG. 2

80°C, 80 % r. F.

DC
Ar:N$_2$ 18:42

DC
Ar:N$_2$ 51:9

d$_{AlOOH}$ (nm)

10,0

1,0

1    10    100

t (h)

EP 0 401 663 A2

# FIG.3

80°C, 80% r. F.

$d_{A100H}$ (nm)

RF
Ar: $N_2$ 10:45

10,0

RF
Ar: $N_2$ 45:10

1,0

1        10        100

t (h)

EP 0 401 663 A2